# EUROPEAN PATENT APPLICATION

(11) **EP 0 551 199 A2**
(43) Date of publication of application: **14.07.1993**
(21) Application number: 93300102.6
(22) Date of filing: 07.01.1993
(51) Int. Cl.: G01R 31/02, G01R 15/12, H02H 7/18, G01R 31/28

(54) **Electrical insulation and continuity tester**

(30) Priority: 08.01.1992 GB 9200273
(71) Applicant: ROBIN ELECTRONICS LIMITED, Watford, Herts WD1 8SS (GB)
(72) Inventor: Harris, David Robert, Kenton, Middlesex, HA 3 8EJ (GB); Litherland, Martin Bernard, Marlborough, Wiltshire (GB); Sehdev, Arun Kumar, South Harrow, Middlesex, HA 2 OLP (GB)
(74) Representative: Ayers, Martyn Lewis Stanley

(57) **Abstract**

An insulation and continuity tester which applies a test voltage for sufficient time to obtain a stable reading and then turns off the test power supply while continuing to display the reading.

## Description

The present invention relates to an electrical test instrument, in particular an insulation and continuity tester, and more particularly to an instrument whose energy consumption is reduced, thereby increasing the life of its battery.

Typical insulation testers use a high voltage (often of the order of 1 kV) in order to stress any points that might be subject to breakdown and simultaneously draw a small test current (often of the order of 1 mA).

Also, a known type of continuity tester has a switched power supply or regulator with a series resistor and develops several volts (typically 4 volts) across two test contacts when open circuit; the source voltage and series resistance are chosen such that several hundred mA (typically 300 mA) flow under short circuit conditions.

For both of the above types of tester, when a test button is pressed, a voltage is generated across a pair of test probes, the measuring system reads the voltage applied across the test probes and the current flowing through them and calculates the external resistance. The result of the test may then be indicated on a display.

In the design of battery operated equipment, the current drain on the battery is an important consideration. As far as insulation and continuity testers are concerned, although the current drain attributable to the measuring circuiting and display can be minimised by the use of low-power integrated circuitry and displays (eg LCD displays), the production of the test stimulus, whether it be the high voltage necessary for an insulation test or the current necessary to establish satisfactory continuity, by necessity involves a relatively heavy drain on the battery. For example, an insulation tester generating 1 kV at 1 mA or a continuity tester in closed circuit might take up to 1.0A from a 9V battery.

Hence, a problem of these testers is that a battery may be rapidly exhausted when making a series of tests and may only have a few hours life.

In view of these problems, an electrical test instrument is proposed having circuitry for producing an electrical test signal. The test instrument also has measurement means for making an electrical measurement with the test signal and control means for controlling energization of the circuitry. The circuitry is controlled by the control means so that energization is interrupted once a measurement can usefully be obtained.

Preferably energization is interrupted once a steady measurement is obtained or alternatively when a measurement can be curve matched to a predetermined curve.

Hence, the present invention may be used in battery powered test instruments, i.e. those using a depletable energy store such as disposable or rechargeable batteries, so as to increase the amount of time which the tester can be used before the battery needs replacing or recharging.

Preferably, the control means controls the energization of the circuitry in accordance with the electrical measurements and to do this may analyze a series of measurements taken at a succession of sampling intervals. Alternatively, the control means may interrupt the energization of the circuitry after a predetermined time interval sufficient for a steady measurement to be obtained.

Preferably, the electrical test instrument may test for continuity and/or insulation breakdown.

Preferably, the present invention comprises a display, but equally, an audio generator such as a buzzer may alternatively or additionally be provided.

Needless to say, some kind of operating switch or button is provided to commence a test. Where a display is provided, the results may be displayed for as long as the switch is in the operating position or alternatively for a predetermined time or until the switch is next placed in an operating position.

Preferably, the electrical test instrument may have an additional mode of operation in which the control means may be prevented from interrupting the energization of the circuitry such that the electrical test signal is produced for as long as the switch is in the operating position.

The invention will be more clearly understood from the following description given by way of example only with reference to the accompanying drawings in which:
Figure 1 illustrates an insulation testing circuit embodying the present invention;
Figure 2 illustrates a continuity testing circuit embodying the present invention;
Figure 3 illustrates the changes in terminal voltage when making an insulation test using a tester of the present invention;
Figure 4 shows the terminal voltage when making a continuity test using the tester of the present invention; and
Figure 5 shows the test current when making a test on an inductive load using the tester of the present invention.

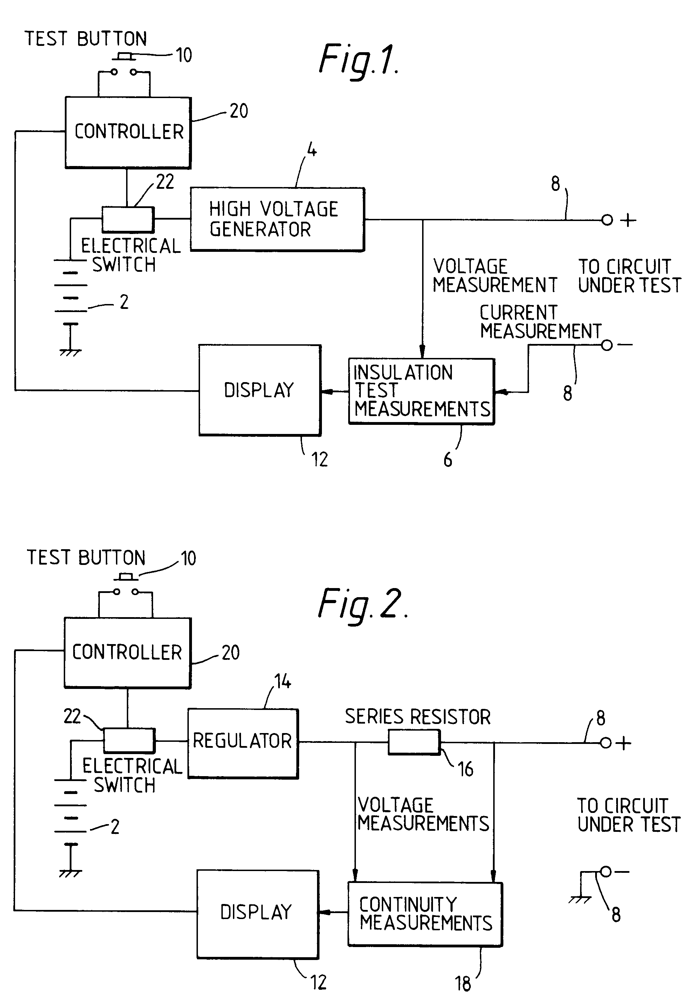

An insulation tester embodying the present invention is illustrated in Figure 1 and comprises a battery 2 supplying a high voltage generator 4 and a resistance measuring system 6 connected to test probes 8. This tester is preferably portable and might be powered from, for instance, 6 AA 1.5V Alkaline cells or 1.5V R6 type batteries. A high voltage (preferably of the order of 1 kV) may be used for testing in order to stress any points in the circuit under test that might be subject to breakdown. The typical test current used in such a tester might preferably be 1 mA and a maximum may be up to 12mA.

An insulation tester of this type might preferably have three test ranges, namely 0-19.99 MOhm, 0-199.9 MOhm and 0-1999 MOhm. The insulation test pressure is preferably chosen from 250 V, 500 V and 1000 V across a minimum of 250 kOhm, 500 kOhm and 1 MOhm respectively.

Referring to Figure 1, when the test button 10 is pressed, a microprocessor 20 operates an electronic switch 22 thereby causing a high voltage to be generated between the pair of test probes 8. The measuring system 6 reads the voltage at the test probe terminals 8 and also the current flowing through them. It thereby calculates the external resistance and this resistance value is then indicated on the display 12 (which may be either analogue or digital and might preferably be LCD to reduce power consumption).

Similarly, the continuity tester illustrated in Figure 2 comprises a switched power supply or regulator 14 with a series resistor 16 which presents several volts (preferably of the order of 4 volts) across the test probes when open circuit; the source voltage and series resistance being preferably chosen such that several hundred mA (typically 300 mA) flow under short circuit conditions, the relevant IEC standard calling for a minimum of 200mA to stress any weak points and to provide a good wetting current (hence a low resistance contact) in the circuit under test.

The measuring system 18 then calculates the external resistance from the voltage dropped by the known series resistor 16.

Preferably, continuity tests may be made with the battery voltage when open circuit and limited by series resistor 16 under short circuit. Further, while the test button 10 is released, a resistance of a suitable value may be switched across the terminals to reduce effects of mains pick-up.

Hence, in these two preferred embodiments of the present invention, the tester is controlled by a microprocessor 20 using an analogue measuring circuit.

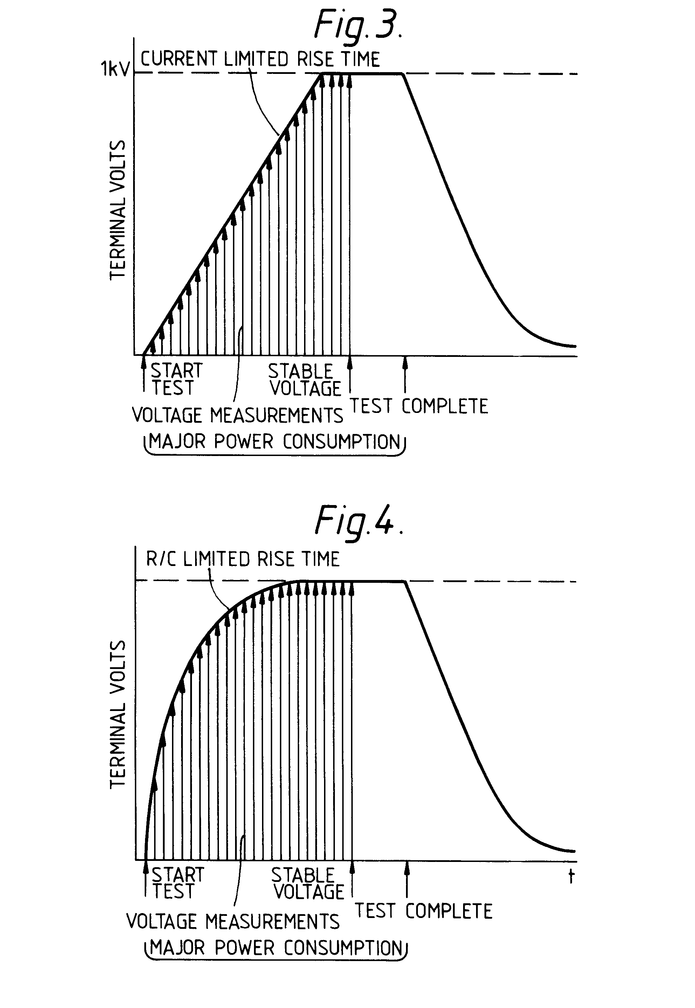

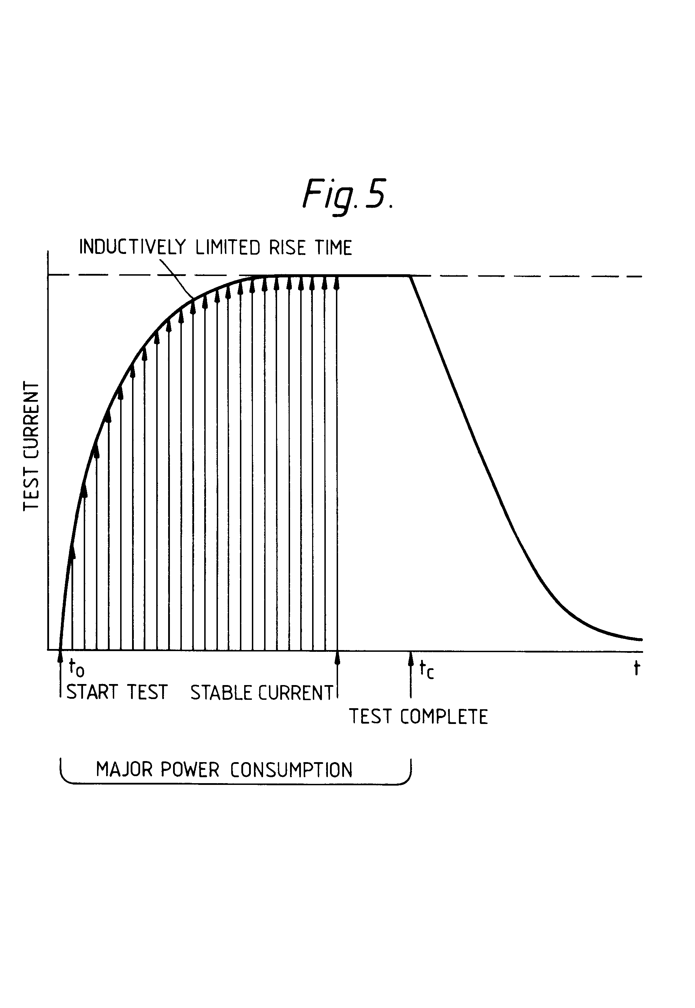

Referring to Figures 3 and 4, the measurements taken and therefore the results which might be displayed by the tester have an initially transient response. This is because the circuit under test often presents a substantial capacitance between the test probes 8. This slows the rise of voltage at the test probes 8, thereby giving incorrect initial results. As illustrated in Figure 3, this problem is particularly acute when insulation testing. In this situation only a limited current (for instance 1.5 mA) is available to charge the external circuit. As seen by Figure 4, however, it also applies to continuity testing of, for example, long mains wiring and to inductive loads as illustrated in Figure 5.

In the preferred embodiment, the microprocessor 20 switches on the power supply 4, by means of the electronic switch 22 and then monitors the voltage across the test probes 8. Once the rate of rise of this voltage is sufficiently small i.e. within a band in which the specified accuracy of the instrument can be achieved, the microprocessor 20 then switches off the power supply 4, 14. Figure 5 shows the application of the invention in circumstances where the measured current is of interest, such as with an adaptation of the apparatus of Figures 1 and 2, in which a constant DC voltage is applied over an interval tₒ to t_{c}, the resulting current waveform being due to the inductive nature of the load under test.

Hence, as illustrated in Figures 3 and 4, a series of voltage measurements are taken at a succession of sampling intervals until a stable voltage is reached. The current flow (insulation test) or series voltage drop (continuity test) is then measured and the power supply 4, 14 may be turned off by means of the switch 22. Lastly, the results of the test, for instance the resistance, is calculated and then shown on the display 12. The results may be held on the display until the test button 10 is released or, alternatively, they may be displayed for a predetermined time or until some other condition is met, for example when the test button 10 is next pressed. Instead of or in addition to the display the tester may produce a control signal for example to operate an audio alarm.

Alternatively, subsequent to applying the test signal to the test probes 8, measurements may be taken until they can be matched to a predetermined curve such as that of a typical RC response curve and then the power supply to the test probes turned off. With this method, the test signal may be turned off earlier than in the above embodiment since the rate of rise can still be relatively high when the test signal is turned off.

Also, for a given application, the test signal to the test probes might automatically be switched off after a predetermined time.

The power source for the display 12 and measuring system 6,18 is not illustrated in the Figures, but may comprise a separate battery or power source or be the battery 2, connected directly and not through the switch 22.

Further, the microprocessor 20 may be connected to the display 12 and the measuring system 6, 18 to directly control them.

Although only one mode of operation has been described so far, which we will call the LOK mode, the tester may have a second mode, which we will call the TRAC mode.

Hence in the LOK mode, the microprocessor 20 detects when the test button 10 is pressed, turns on the power supply 4, 14 by means of the electronic switch 22 and then determines when to turn off the power supply 4, 14. Hence, a single measurement is made and the test signals removed for each press of a test button.

However, in the TRAC mode, the tester behaves in a manner similar to that of a conventional tester i.e. the voltage is applied at the test probes 8 as for long as the start button 10 is held down, readings being taken continuously. In other words, the test signals are applied continuously and the displays are periodically updated while the button is held down. Such an operation may be achieved by the microprocessor 20 responding to the test button 10 in a different manner or alternatively, though not illustrated, another test button might bypass the electronic switch 22.

Whether capable of two modes of operation or not the two testers i.e. for insulation or continuity may be combined together in a single unit, with or without further test features such as those available with multitesters. In such a combined tester a switch may be provided to choose which test and hence which circuit is required. Further, in such a tester the two or more circuits may share common components for example, the LCD display 12.

A further feature which can be included on the tester is a bar graph display and in the TRAC mode, the test voltage's magnitude may be displayed in real time on the bar graph, while a resistance reading is displayed visually.

A further embodiment is now described which uses a bar graph display in a novel function and also a numeric display.

During a test, the instrument will preferably provide a test current of typically 1.2 mA at minimum circuit load resistance, the minimum test current at maximum load will be 1 mA and the test pressure will fall as the current demand exceeds typically 1.2 mA. While the test button is up, external charge in the test circuit can be dumped through a resistor, the voltage between the test lead probes may be shown on the bar graph display and a right hand (RH) 0 may be shown on the numeric display.

Where there is an external a.c. voltage in excess of 20 Vr.m.s and preferably even when the tester is not activated or is in an "off" state, the numeric display may clear to show an AC and a 'Lightning' warning symbol flashing in order to give an indication of dangerous voltages to the user. Further, a bleeper may be made to warble loudly and be distinct from an end-of-test signal which might be used. In this situation, the instrument will not respond to the test button in order to protect the instrument's circuits and also the user.

Note that a high d.c. voltage is not unexpected in insulation tests and the instrument will not inhibit a test in this case.

When the test button is pressed in TRAC mode an insulation test voltage is applied and the bar graph can show the terminal voltage as it increases. The numeric display may show a RH (Right Hand) 0.

Once a stable resistance measurement has been reached the value may be shown on the numeric display with the M0hms unit and a bleeper may sound at a low level. A measurement reading greater than the f.s.d of the selected range can be made to result in an over-range symbol being shown with the M0hms unit.

While the test button is held or locked down in TRAC mode, the test voltage is applied continuously and the instrument may be such that every 2 seconds a fresh measurement is made, the numeric display is updated and the bleeper sounds at a low level. Meanwhile the test probe voltage may be measured every 100ms and the bar graph may be updated. The bar graph may also show circuit breakdown if it occurs.

Where the test button is released in TRAC mode the test voltage is removed and the bar graph shows the terminal voltage as it decays. The result shown on the numeric display clears to a RH 0 after 1 second (or alternatively 5 seconds) or immediately if the test button is pressed again to do another test.

However, when the test button is pressed in LOK mode, the insulation test voltage is applied, the bar graph shows the increasing terminal voltage and a RH 0 is displayed.

Once a stable reading is reached this is shown on the numeric display with the M0hms unit. Then the test voltage is removed and the bleeper sounds at a low level.

The bar graph follows the charging voltage as it ramps up before making the measurement and as it then decays.

While the test button is held or locked down in LOK mode, the measurement reading is held on the numeric display. The bar graph continues to show the terminal voltage as it decays.

When the test button is released in LOK mode the display clears to a RH 0 after 1 second or immediately if the test button is pressed again to do another test.

The measurement accuracy of the instrument will preferably meet the relevant standards:
+-1.5% of reading +- 1 digit on continuity ranges
+-1.5% of reading +- 1 digit on 20 M0hm, 200 M0hm
+-3% of reading +- 1 digit on 2 G0hm range up to 1G0hm at 1kV.
+-10% of reading +- 1 digit on 2 G0hm range up to 2 G0hm at 250V and 500V.

Likewise, the voltage output accuracy for the insulation test will preferably meet the relevant standards: ± 5% of nominal at minimum circuit load resistance.

Hence, the present invention offers substantial power saving because the test power supply 4, 14 is only switched on for the minimum time required to take a reading. It is ideally suited to battery powered testers since the time of major power consumption as illustrated in Figure 3 and 4 is kept to a minimum.

## Claims

1. An electrical test instrument comprising circuitry (4,14,22) for producing an electrical test signal, measurement means (6,18) for making an electrical measurement with the test signal and control means (20) for controlling energization of the test signal producing circuitry (4,14,22) so that its energization is interrupted once a state is reached in which a measurement can be obtained.

2. An electrical test instrument according to claim 1 wherein said energization is interrupted once a steady measurement is obtained.

3. An electrical test instrument according to claim 1 wherein said energization is interrupted when a measurement can be curve matched to a predetermined curve.

4. An electrical test instrument according to claim 1, 2 or 3 and which is battery-operated.

5. An electrical test instrument according to any one of the preceding claims wherein, in use, said control means (20) controls the energization of the test signal producing circuitry (4,14,22) by monitoring the electrical measurements taken.

6. An electrical test instrument according to any one of the preceding claims and which provides an electrical continuity test.

7. An electrical test instrument according to any one of the preceding claims and which provides a test for insulation breakdown.

8. An electrical test instrument according to any one of the preceding claims comprising a display (12) for displaying results.

9. An electrical test instrument according to any one of the preceding claims comprising a switch (10) operable to commence a test.

10. An electrical test instrument according to claims 8 and 9 wherein in use results of a test are displayed for as long as the switch (10) is operated.

11. An electrical test instrument according to claim 8 and 9 wherein in use results of the test are displayed for a predetermined time from the switch (10) being operated.

12. An electrical test instrument according to claim 9, 10 or 11 wherein in use said control means (20) may be prevented from interrupting the energization of said circuitry (4,14,22) such that the electrical test signal is produced for as long as the switch (10) is operated.
